(19) Europäisches Patentamt

European Patent Office

Office européen des brevets

(11) **EP 1 650 323 A1**

(12) **EUROPEAN PATENT APPLICATION**

(43) Date of publication:
 **26.04.2006 Bulletin 2006/17**

(51) Int Cl.:
 **C23C 14/34** (2006.01)

(21) Application number: **05021951.8**

(22) Date of filing: **07.10.2005**

| | |
|---|---|
| (84) Designated Contracting States:<br>**AT BE BG CH CY CZ DE DK EE ES FI FR GB GR**<br>**HU IE IS IT LI LT LU LV MC NL PL PT RO SE SI**<br>**SK TR**<br>Designated Extension States:<br>**AL BA HR MK YU** | (72) Inventor: **Moyama, Kazuki**<br>**Takasago Works in Kobe Steel, Ltd.**<br>**Takasago-shi**<br>**Hyogo 676-8670 (JP)** |
| (30) Priority: **19.10.2004 JP 2004304700** | (74) Representative: **Müller-Boré & Partner**<br>**Patentanwälte**<br>**Grafinger Strasse 2**<br>**81671 München (DE)** |
| (71) Applicant: **Kobelco Research Institute, Inc.**<br>**Kobe-shi**<br>**Hyogo 651-0073 (JP)** | |

(54) **Assembly for sputtering aluminium-neodymium alloys**

(57) To reduce warp caused by bonding or film deposition and enable stable film deposition over a long time, an assembly for sputtering Al-Nd alloys includes an Al-Nd alloy sputtering target containing an aluminum alloy having a Nd content of 0.1 to 3 atomic %, and a backing plate brazed to the Al-Nd alloy sputtering target, in which the Al-Nd alloy sputtering target has an average coefficient of linear expansion A at temperatures of 25°C to 100°C, and the backing plate has an average coefficient of linear expansion B at temperatures of 25°C to 100°C, and A and B satisfy following Condition (1):

$$-0.15 \leq (B-A)/A < 0.15 \qquad (1)$$

# FIG.1

EP 1 650 323 A1

**Description**

The present invention relates to assemblies for sputtering Al-Nd alloys. Specifically, it relates to assemblies for sputteringAl-Nd alloys, which contain anAl-Nd alloy sputtering target and a backing plate brazed to the Al-Nd alloy sputtering target and enable stable film deposition operation over a long period of time by reducing warp caused by bonding or film deposition (sputtering) of Al-Nd alloy thin films and thereby.

A sputtering process is generally employed for the deposition of thin films constituting liquid crystal panels and organic electroluminescence (EL) panels for use in television sets, laptop computers, and other monitors, and interconnection films for use in the fields of optical recording and semiconductors. In the sputtering process, plasma discharge is induced between a substrate and a target serving as a material for films, a gas ionized by the plasma discharge is collided to the target to thereby beat atoms out of the target, and the atoms are deposited on the substrate to thereby fabricate a thin film. This process is advantageous in that a thin film having the same composition as the target can be deposited, in contrast to vacuum vapor deposition and arc ion plating (AIP).

A flat target having, for example, a rectangular or orbicular shape is generally used in the sputtering process. The target is generally brazed to a backing plate (also referred to as cooling plate or support) for cooling and/or support the target.

In general, copper or copper alloy backing plates featured by high thermal conductivities are used as the backing plate for the purpose of cooling the target heated upon film deposition. The target often comprises a metal material corresponding to the thin film to be deposited, such as aluminum, aluminum alloys, Mo, Ta or Ti, being different from that of the backing plate.

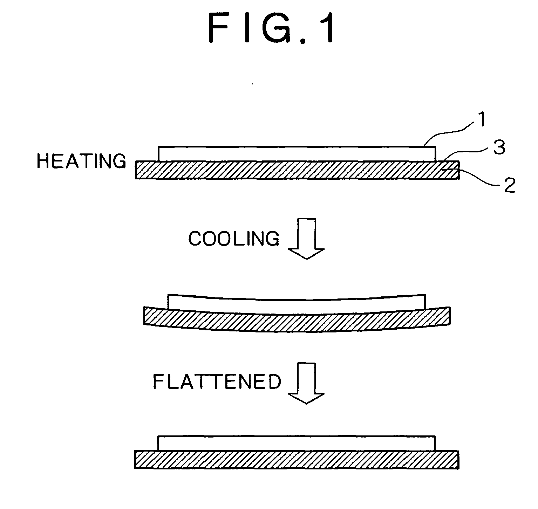

The resulting assembly prepared by brazing these members comprising different metal materials, however, often warps and must be flattened as illustrated in FIG. 1. When the flattened assembly is subjected to film deposition, it will again warp due to repetitive heating and cooling. Thus, procedures of film deposition, in which the assembly warps, and flattening of the warped assembly must be repeated again and again, which results in complicated operations. In addition, a brazing filler metal 3 arranged between the target 1 and the backing plate 2 undergoes cracking to thereby cause delamination of the target 1 and the backing plate 2 before the consumption of the target 1. Thus, repetitive film deposition cannot be achieved.

As a possible solution to the problem in brazing between a target and a backing plate (support), Japanese Patent Application Laid-Open (JP-A) No. 2003-183822 discloses a sputtering target including a target and a backing plate bonded with the interposition of a bonding member, in which the backing plate has a concave portion for housing the bonding member, and the concave portion has a communicating recess in its outer peripheral wall, which recess communicates to the concave portion. The document mentions that this structure prevents warp of the target even when the bonding member solidifies and shrinks. This technique, however, does not aimat the prevention of delamination of the bonding portion (brazing filler metal) and must use a backing plate having a complicated shape.

Japanese Patent Application Laid-Open (JP-A) No. 08-246144 proposes a technique for preventing warp and cracking of a sputtering target and delamination of a brazing portion by arranging a plate member having a higher coefficient of thermal expansion and another plate member having a lower coefficient of thermal expansion than the sputtering target so as to integrally sandwich a backing plate. This prevents warp of the backing plate and imparts thermal expansion properties equivalent to those of the target to be supported to the sputtering target. This technique, however, is also disadvantageous in complicated structure of the backing plate.

Japanese Patent Application Laid-Open (JP-A) No. 10-046327 proposes a technique of fabricating a target and a backing plate from an aluminum alloy, for the purpose of reducing the difference in coefficient of linear expansion between the two members. The combination of the target with the backing plate according to the technique does not sufficiently and reliably reduce the difference in coefficient of thermal expansion and does not prevent cracking of the brazing filler metal when an Al-Nd alloy is used as the target.

Under these circumstances, an object of the present invention is to provide an assembly for sputtering Al-Nd alloys, which contains an Al-Nd alloy sputtering target and a backing plate brazed to the Al-Nd alloy sputtering target, is reduced in warp caused by bonding and/or stress caused by film deposition (sputtering) of Al-Nd alloy thin films, saves the flattening of the warp and thereby enables stable film deposition operation over a long period of time.

Specifically, the present invention provides an assembly for sputtering Al-Nd alloys, including anAl-Nd alloy sputtering target containing an aluminum alloy containing 0. 1 to 3 atomic % of Nd, and a backing plate brazed to the Al-Nd alloy sputtering target, in which the Al-Nd alloy sputtering target has an average coefficient of linear expansion A at temperatures of 25°C to 100°C, and the backing plate has an average coefficient of linear expansion B at temperatures of 25°C to 100°C, and A and B satisfy following Condition (1):

$$-0.15 \leq (B-A)/A < 0.15 \qquad\qquad (1)$$

The average coefficient of linear expansion is determined by using a testing instrument Thermoflex TMA 8140 available fromRigaku Corporation according to "Test Method of Coefficient of Linear Expansion of Plastics by Thermomechanical Analysis" specified in Japanese Industrial Standards (JIS) K 7197.

The backing plate constituting the assembly preferably contains an aluminum alloy, of which an aluminum alloy of JIS A 5052 or A 6061 is typically preferred.

The backing plate typically preferably contains the same aluminum alloy as the Al-Nd alloy sputtering target, for easily satisfying Condition (1).

The assembly according to the present invention, including an Al-Nd alloy sputtering target containing Nd, and a backing plate brazed to the Al-Nd alloy sputtering target is reduced in warp occurring upon bonding or film deposition (sputtering) of Al-Nd alloy thin films, thereby saves the flattening of the warp, is reduced in cracking the brazing filler metal for bonding the target and the backing plate and enables stable film deposition operation over a long period of time.

Further objects, features and advantages of the present invention will become apparent from the following description of the preferred embodiments with reference to the attached drawings.

FIG. 1 is a side view schematically illustrating cracking in a brazed portion; and

FIG. 2 is a top view showing measurement points on warp of an assembly in the bonding test in the examples.

The present inventors made intensive investigations to provide an assembly comprising an Al-Nd alloy sputtering target and a backing plate brazed to the Al-Nd alloy sputtering target (hereinafter briefly referred to as "assembly"), which is reduced in warp caused by heating and subsequent cooling in bonding or film deposition, thereby saves the flattening of the warp, is reduced in cracking of a brazing filler metal between the target and the backing plate caused by repetitive warp and flattening thereof and thereby enables stable film deposition operation over a long period of time by preventing.

Consequently, they have found that, when the Al-Nd alloy sputtering target has an average coefficient of linear expansion A at temperatures of 25°C to 100°C, and the backing plate has an average coefficient of linear expansion B at temperatures of 25°C to 100°C, the difference between B and A should be 15% or less of A, as in following Condition (1):

$$-0.15 \leq (B-A)/A < 0.15 \qquad (1)$$

The assembly according to the present invention has only to have average coefficients of linear expansion of the Al-Nd alloy sputtering target and the backing plate at temperatures of 25°C to 100°C satisfying Condition (1). The material, for example, and other configurations of the backing plate are not specifically limited. For efficiently yielding an assembly satisfying Condition (1), however, it is effective to control the average coefficient of linear expansion of the backing plate according to theAl-Nd alloy sputtering target used. The backing plate preferably comprises an aluminum alloy. The aluminum alloy can be any existing articles comprising aluminum alloys, of which aluminum alloys of JIS A 5000 or A 6000 series are preferred, and an aluminum alloy of JIS A 5052 or A 6061 is typically preferred.

The assembly specifically preferably comprises an Al-Nd alloy sputtering target and a backing plate both comprising the same aluminum alloy, from the viewpoint of reducing difference in average coefficient of linear expansion at 25°C to 100°C between the Al-Nd alloy sputtering target and the backing plate.

These aluminum alloys have thermal conductivities lower than those of Cu-based materials but can serve to cool the brazed target sufficiently.

The backing plate constituting the assembly according to the present invention may have an inner structure for cooling the target. The cooling structure can be any conventional structure. For example, two members for constituting the backing plate is bonded typically by welding, friction welding or diffusion bonding so as to form a coolant passage in the backing plate. In addition or alternatively, any facilities such as power source or mounting parts for mounting to film deposition equipment may be mounted to the backing plate.

The Al-Nd alloy sputtering target containing 0.1 to 3 atomic % of Nd and constituting the assembly can be fabricated, for example, by vacuum melting-casting process, spray forming process or powder sintering process, of which spray forming process is preferred. When the sputtering target is manufactured by the spray forming process, an alloying element, if any, is uniformly dissolved or dispersed in the host phase aluminum to yield a uniform material.

The sputtering target can be fabricated by the spray forming process, for example, in the followingmanner. Amoltenmaterial is dripped from a nozzle having a diameter of several millimeters, $N_2$ gas, for example, is blown to the drops topowderize the material, and the powderedmaterial is formed into an intermediate material called "preform" having a density of about 50% to about 60% before complete solidification of the material. The intermediate material is converted into a dense texture by using a hot isostatic pressing (HIP) machine and is forged into a plate-like metallic member and is rolled so as to have substantially the same thickness as the target. The conditions in fabrication processes such as HIP, forging and rolling processes can be conventional or regular conditions.

The assembly according to the present invention is subjected to film deposition while having the sputtering target brazed onto a plane surface of the backing plate. The brazing filler metal and brazing method herein are not specifically limited and conventional or general materials and methods can be employed. The assembly enables repetitive film deposition satisfactorily even using a regular brazing filler metal such as indium, lead-tin solder or tin-zinc solder.

The assembly according to the present invention is not specifically limited in its shape and dimensions and can have a variety of shapes such as rectangular shape or orbicular shape. The present invention is preferably applied to a large-sized assembly having an area in a brazing portion brazed with the target of 0.25 $m^2$ or more. This is because the defects such as cracking of the brazing filler metal become significant with an increasing size of the assembly.

The present invention will be illustrated in further detail with reference to several experimental examples below which by no means limit the scope of the present invention. Any modification of such examples without deviating from the scope of the present invention is within the technical range of the present invention.

An Al-2 at % Nd sputtering target 400 mm long and 500 mm wide and a series of backing plates (cooling plates) 420 mm long and 520 mm wide comprising a variety of materials listed in Table 1 were used. The average coefficients of linear expansion of the Al-2 at % Nd sputtering target and the backing plates at temperatures of 25°C to 100°C were determined using a testing instrument Thermoflex TMA 8140 available from Rigaku Corporation according to "Test Method of Coefficient of Linear Expansion of Plastics by Thermomechanical Analysis" specified in Japanese Industrial Standards (JIS) K7197 . The ratio (B-A) /A was determined from the average coefficient of linear expansion A of the target at 25°C to 100°C and the average coefficient of linear expansion B of the sample backing plate at 25°C to 100°C. The results are shown in Table 1.

Table 1

| Sample No. | Target | | Backing plate (cooling plate) | | (B-A)/A | Measured warp (mm) | | | | | | | |
|---|---|---|---|---|---|---|---|---|---|---|---|---|---|
| | Material | Average coefficient of linear expansion A at 25°C to 100°C ($\times 10^{-6}$/°C) | Material | Average coefficient of linear expansion B at 25°C to 100°C ($\times 10^{-6}$/°C) | | Measurement point L1 | L2 | L3 | W1 | W2 | W3 | D1 | D2 |
| 1 | Al-2 at % Nd | 22.8 | A 5052 | 24.5 | 0.075 | 0.59 | 0.56 | 0.56 | 0.27 | 0.40 | 0.36 | 0.78 | 1.01 |
| 2 | Al-2 at % Nd | 22.8 | A 6061 | 23.6 | 0.035 | 0.43 | 0.39 | 0.39 | 0.26 | 0.27 | 0.26 | 0.51 | 0.49 |
| 3 | Al-2 at % Nd | 22.8 | A 1100+7 mass % Si | 22.4 | -0.018 | 0.30 | 0.31 | 0.23 | 0.20 | 0.18 | 0.21 | 0.42 | 0.38 |
| 4 | Al-2 at % Nd | 22.8 | JIS C 1020 (Cu) | 16.9 | -0.26 | 3.93 | 4.38 | 4.13 | 2.88 | 2.90 | 2.42 | 6.52 | 5.59 |

Note: at% is referred to as atomic %.

Table 1 demonstrates that Sample Nos. 1-3 satisfy the requirement as specified in the present invention in average coefficient of linear expansion between the Al-Nd alloy target and the backing plate (cooling plate). In contrast, Sample No. 4 does not satisfy the requirement and has a large difference in average coefficient of linear expansion between the Al-Nd alloy sputtering target and the backing plate (cooling plate).

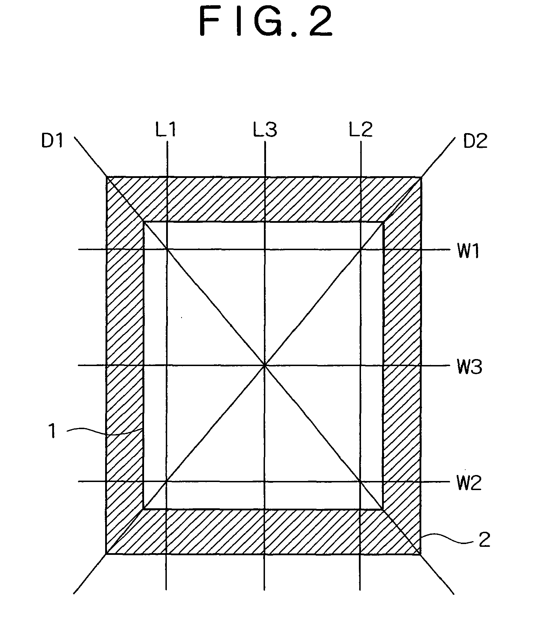

Next, each of the backing plates (cooling plates) listed in Table 1 was bonded to the Al-Nd alloy sputtering target to fabricate a series of assemblies, and the warp of the assemblies was determined. Specifically, the target was bonded to the backing plate using a tin-zinc solder while heating at 250°C, and the warp of the resulting assembly was determined at the points in FIG. 2. The results are also shown in Table 1. The measurement points such as L1 and L2 in Table 1 represent the measurement points in FIG. 2.

Table 1 demonstrates that assemblies for sputtering Al-Nd alloys of Sample Nos. 1-3 comprise an Al-Nd alloy sputtering target in combination with a backing plate satisfying the requirement in the present invention, have little warp after bonding and do not require flattening of the warp, and that the assembly of Sample No. 4 does not satisfy the requirement in the present invention, shows significant warp after bonding and must be flattened.

While the present invention has been described with reference to what are presently considered to be the preferred embodiments, it is to be understood that the invention is not limited to the disclosed embodiments. On the contrary, the invention is intended to cover various modifications and equivalent arrangements included within the spirit and scope of the appended claims. The scope of the following claims is to be accorded the broadest interpretation so as to encompass all such modifications and equivalent structures and functions.

**Claims**

1. An assembly for sputtering Al-Nd alloys, comprising:

   an Al-Nd alloy sputtering target comprising an aluminum alloy containing 0.1 to 3 atomic % of Nd; and
   a backing plate brazed to the Al-Nd alloy sputtering target,
   wherein the Al-Nd alloy sputtering target has an average coefficient of linear expansion A at temperatures of 25°C to 100°C, and the backingplate has an average coefficient of linear expansion B at temperatures of 25°C to 100°C, and
   wherein A and B satisfy following Condition (1):

$$-0.15 \leq (B-A)/A < 0.15 \qquad\qquad (1)$$

2. The assembly according to claim 1, wherein the backing plate comprises an aluminum alloy.

3. The assembly according to claim 2, wherein the backing plate comprises an aluminum alloy of Japanese Industrial Standards (JIS) A 5052 or A6061.

4. The assembly according to claim 2, wherein the backing plate comprises the same aluminum alloy as the Al-Nd alloy sputtering target.

# FIG.1

HEATING

1

3

2

COOLING ⇩

FLATTENED ⇩

# F I G . 2

**European Patent Office**

## EUROPEAN SEARCH REPORT

Application Number

EP 05 02 1951

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | PATENT ABSTRACTS OF JAPAN vol. 2000, no. 21, 3 August 2001 (2001-08-03) & JP 2001 093862 A (VACUUM METALLURGICAL CO LTD), 6 April 2001 (2001-04-06) *Example 1, Comparative Example 1* * abstract * | 1-4 | C23C14/34 |
| Y | US 2004/113364 A1 (IVANOV EUGENE) 17 June 2004 (2004-06-17) * paragraph [0006] * | 1-4 | |
| A | WO 02/22300 A (TOSOH SMD, INC; IVANOV, EUGENE, Y) 21 March 2002 (2002-03-21) * page 9, lines 16-19 * | 1-3 | |

| | |
|---|---|
| | TECHNICAL FIELDS SEARCHED (IPC) |
| | C23C |

The present search report has been drawn up for all claims

| Place of search | Date of completion of the search | Examiner |
|---|---|---|
| Munich | 14 December 2005 | Hoyer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 05 02 1951

This annex lists the patent family members relating to the patent documents cited in the above-mentioned European search report.
The members are as contained in the European Patent Office EDP file on
The European Patent Office is in no way liable for these particulars which are merely given for the purpose of information.

14-12-2005

| Patent document cited in search report | | Publication date | Patent family member(s) | | Publication date |
|---|---|---|---|---|---|
| JP 2001093862 | A | 06-04-2001 | JP | 3634208 B2 | 30-03-2005 |
| US 2004113364 | A1 | 17-06-2004 | NONE | | |
| WO 0222300 | A | 21-03-2002 | EP | 1322444 A1 | 02-07-2003 |

For more details about this annex : see Official Journal of the European Patent Office, No. 12/82